# EUROPEAN PATENT APPLICATION

(11) **EP 1 205 575 A1**
(43) Date of publication of application: **15.05.2002**
(21) Application number: 01917596.7
(22) Date of filing: 29.03.2001
(51) Int. Cl.: C23C 16/40, C23C 14/08, C23C 14/22, H01L 21/31, H01L 21/316, H01L 27/10, H01L 41/22

(54) **METHOD FOR PRODUCING CERAMIC AND APPARATUS FOR PRODUCING THE SAME, SEMICONDUCTOR DEVICE, AND PIEZOELECTRIC DEVICE**

(30) Priority: 29.03.2000 JP 2000091603
(71) Applicant: Seiko Epson Corporation, Shinjuku-ku, Tokyo 163-0811 (JP)
(72) Inventor: NATORI, Eiji, SEIKO EPSON CORPORATION, Suwa-shi, Nagano 392-8502 (JP)
(74) Representative: Hoffmann, Eckart, Dipl.-Ing.
(86) International application number: JP0102631
(87) International publication number: WO0173161

(57) **Abstract**

A ceramics fabricating method which includes a step of forming a ceramic film by feeding an electromagnetic wave (200A) and an active species (100A) of a substance which is at least part of raw materials for the ceramics to a predetermined region. A film including a substance which is part of the raw materials for the ceramics may be formed in the predetermined region. The fabrication method further includes a step of feeding the active species (100A) and the electromagnetic wave (200A) to a first ceramic film (20a) to form a second ceramic film which has a crystal structure differing from that of the first ceramic film (20a).

## Description

### TECHNICAL FIELD

The present invention relates to a method and a device for fabricating ceramics such as an oxide film, nitride film, and ferroelectric film, and a semiconductor device and a piezoelectric device using the ferroelectric film.

### BACKGROUND ART

In the case of forming ferroelectric materials such as PZT (Pb(Zr,Ti)O₃) and SBT (SrBi₂Ta₂O₉), a high process temperature is needed. For example, formation of PZT generally requires a temperature of 600-700°C, and formation of SBT requires a temperature of 650-800°C. Characteristics of the ferroelectrics depend on their crystallinity. In general, ferroelectrics having higher crystallinity have superior characteristics.

In semiconductor devices equipped with a capacitor including a ferroelectric film (ferroelectric capacitor) such as ferroelectric memory devices, characteristics such as residual polarization characteristics, coercive field characteristics, fatigue characteristics, and imprint characteristics are significantly affected by the crystallinity of the ferroelectrics. Since the ferroelectrics are polyatomic and have a complicated perovskite crystal structure, atoms must be provided with a large amount of migration energy in order to obtain ferroelectrics having good crystallinity. As a result, a high process temperature is required for crystallization of the ferroelectrics.

However, if the process temperature for the ferroelectric film is increased, ferroelectric memory devices tend to be damaged. Specifically, crystallization of the ferroelectrics requires a high-temperature heat treatment in an oxygen atmosphere. Insulating layers formed during this high-temperature heat treatment due to oxidization of polysilicon or electrode materials cause the characteristics of the ferroelectric capacitor to deteriorate. Moreover, transistor characteristics of the semiconductors deteriorate due to heat. Furthermore, Pb and Bi which are constituent elements for PZT and SBT tend to be easily diffused. These elements are diffused into the semiconductor devices, thereby causing the semiconductor devices to deteriorate. Such deteriorations become significant as the process temperature for the ferroelectric film increases and the semiconductor devices are integrated to a higher degree (semiconductor devices with an integration degree of 1 Mbit or more, for example).

Therefore, ferroelectric capacitors have been applied to semiconductor devices integrated to such a degree that the devices are less affected even if the process temperature for the ferroelectric film is increased (1-256 Kbit, for example). However, an integration degree from 16 Mbit to Gbit has already been required for a DRAM, flash memory, and the like, whereby application fields for the ferroelectric memory devices are limited. In the case of preventing the deterioration of the devices due to a high-temperature oxygen atmosphere by decreasing the process temperature for the ferroelectrics, crystallinity of the ferroelectric film decreases. As a result, the residual polarization characteristics of the ferroelectric capacitors decreases, whereby fatigue characteristics, imprint characteristics, retention characteristics, and the like also decrease.

### DISCLOSURE OF THE INVENTION

An objective of the present invention is to provide a method and a device of fabricating ceramics excelling in characteristics such as crystallinity with a reduced process temperature.

Another objective of the present invention is to provide a semiconductor device and a piezoelectric device using the ceramics obtained by the method of the present invention.

### (A) First fabrication method

According to a first aspect of the present invention, there is provided a method of fabricating ceramics, comprising a step of forming a ceramic film by feeding an electromagnetic wave and an active species of a substance which is at least part of raw materials for the ceramics to a predetermined region.

According to this fabrication method, migration energy in the film can be increased by the multiplier effects by applying the active species and the electromagnetic wave to the film, whereby ceramics having excellent film quality can be formed. Moreover, not only the migration energy of the active species but also the density of the active species can be increased by applying the electromagnetic wave to the predetermined region. As a result, ceramics can be formed at a lower process temperature in comparison with the case of feeding neither the active species nor the electromagnetic wave. For example, in the case of forming ferroelectrics, a process temperature of preferably less than 600°C, and more preferably 450°C or less can be employed.

These effects are the same as in other features of this aspect of the present invention.

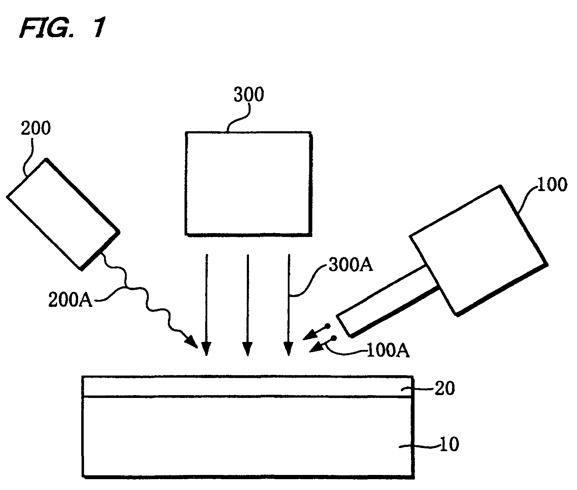

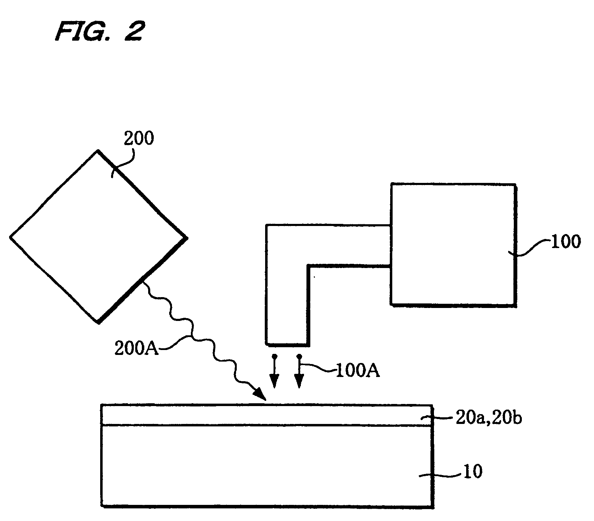

The above-described method has following features.
(1) The active species of a substance which is at least part of the raw materials for the ceramics, the electromagnetic wave, and other reactive species of the raw materials for the ceramics may be fed to the predetermined region. According to this fabrication method, film-forming and crystallization of the ceramics can be performed at the same time.
   In this fabrication method, active species 100A, other reactive species 300A, and an electromagnetic wave 200A are fed to a substrate 10 in the region in which a ceramic film 20 is formed, as shown in Figure 1. The ceramic film 20 is formed by allowing the reactive species 300A to react with the active species 100A. The electromagnetic wave 200A and the active species 100A activate the reaction between the reactive species 300A and the active species 100A, and increase the migration energy of atoms in the film. The active species 100A, electromagnetic wave 200A, and reactive species 300A are appropriately selected depending on the composition and the crystal structure of the resulting ceramics, the use for the ceramics material, and the like.
   The active species 100A are generated in an active species feeder 100. The reactive species 300A is fed through a reactive species feeder 300. The electromagnetic wave 200A is fed from an electromagnetic wave generating section 200.
(2) A film including a substance which is part of raw materials for the ceramics may be formed in the predetermined region. According to this fabrication method, film-forming and crystallization of the ceramics can be performed at the same time in the same manner as in the method of the above (1). However, this method differs from the method of (1) in that the substance which is part of the raw materials for the ceramics is formed into a film.
   In this fabrication method, a film 20a including a substance which is part of the raw materials for the ceramics is formed on the substrate 10, as shown in Figure 2. The film 20a reacts with the active species 100A by feeding the active species 100A from the active species feeder 100 and the electromagnetic wave 200A from an electromagnetic wave generating section 200 to the predetermined region, thereby forming the ceramic film. The electromagnetic wave 200A and the active species 100A activate the reaction between the film 20a and the active species 100A, and increase the migration energy of atoms in the film.
(3) The method of fabricating ceramics may comprise a step of feeding an active species and an electromagnetic wave to a first ceramic film to form a second ceramic film which has a crystal structure differing from the crystal structure of the first ceramic film.

In this fabrication method, the migration energy of atoms in a first ceramic film 20c is increased by feeding the active species 100A from the active species feeder 100 and the electromagnetic wave 200A from the electromagnetic wave generating section 200 to the first ceramic film 20c on the substrate 10, as shown in Figure 2, whereby the second ceramic film having high crystallinity can be formed.

The first ceramic film may be formed of ceramics in an amorphous state or ceramics having low crystallinity. In such a first ceramic film, the migration energy of atoms is increased by applying the active species 100A and the electromagnetic wave 200A, whereby the second ceramic film having high crystallinity is obtained.

The above-described effects of the first fabrication method are the same as in other fabrication methods according to the present invention.

In this method, the thickness of the ceramic film may be 5 nm to 30 nm. If the thickness of the film is within this range, the effect of increasing the migration energy of atoms by the electromagnetic wave and active species can be obtained in the entire film. If the thickness of the film is less than 5 nm, the composition of the film tend to become uneven. If the thickness of the film is more than 30 nm, it is difficult to obtain the effect of increasing the migration energy of atoms in the entire film.

### (B) Second fabrication method

According to a second aspect of the present invention, there is provided a second fabrication method wherein a ceramic film having a predetermined thickness can be formed by repeating several times a step of forming a thin ceramic film having a predetermined thickness by the first fabrication method. There are following features of this fabrication method.
(1) In the same manner as in the above (A) (1), a film having a predetermined thickness may be formed by repeating several times a step of forming a ceramic film having a predetermined thickness by feeding at least one of an electromagnetic wave and active species of a substance which is at least part of raw materials for the ceramics to a predetermined region.
(2) In the same manner as in the above (A) (2), a film including a substance which is part of the raw materials for the ceramics may be formed in the predetermined region.
(3) This ceramics fabrication method may comprise: a first step of forming a first ceramic film; and a second step of feeding at least one of an electromagnetic wave and active species to the first ceramic film to form a second ceramic film which has a crystal structure differing from the crystal structure of the first ceramic film, in the same manner as in the above (A) (3), and a film having a predetermined thickness can be formed by performing alternately the first and second steps.

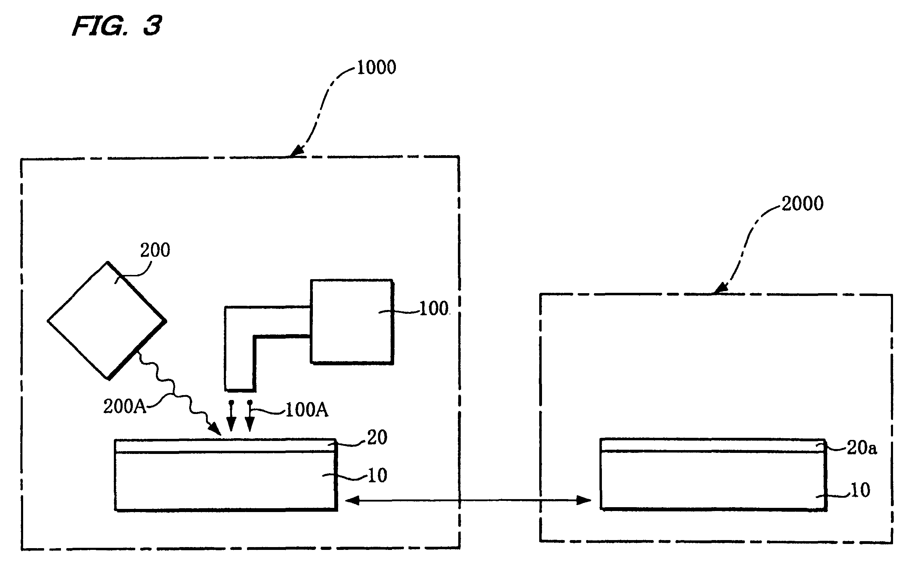

In this fabrication method, the first film 20a is formed on the substrate 10 in a film forming section 2000, as shown in Figure 3. The substrate 10 on which the first ceramic film 20a is formed is transferred to a crystallization section 1000. In the crystallization section 1000, the active species 100A and the electromagnetic wave 200A are fed to the first ceramic film 20a respectively from the active species feeder 100 and the electromagnetic wave generating section 200, whereby the first ceramic film 20a is crystallized to form the second ceramic film 20. These film-forming and crystallization steps are performed repeatedly.

In this second fabrication method, the thickness of the ceramic film or the second ceramic film may be 5-30 nm in the same manner as in the first fabrication method.

### (C) Third fabrication method

According to a third aspect of the present invention, there is provided a third fabrication method wherein a ceramic film is not formed on the entire surface of the substrate, but formed in part, specifically, in a minute region. This method has some features as follows.
(1) A region for forming a ceramic film may be part of a substrate; and the method may comprise a step of forming the ceramic film by feeding at least one of an electromagnetic wave and active species of a substance which is at least part of raw materials for the ceramics to a predetermined region.
(2) In the same manner as in the above (A) (2), a film including a substance which is part of the raw materials for the ceramics may be formed in the predetermined region.
(3) A region for forming a ceramic film may be part of a substrate; and the method may comprise a step of feeding at least one of active species and an electromagnetic wave to a first ceramic film to form a second ceramic film which has a crystal structure differing from the crystal structure of the first ceramic film.
(4) There may be a method of forming a ceramic film on part of the substrate. Specifically, The method may comprise a step of forming a film-forming region having affinity to ceramics to be formed and a non-film-forming region having no affinity to ceramics to be formed on a surface of the substrate, to form self-alignably a ceramic film in the film-forming region.

### (D) Other methods

In addition, the above-described fabrication methods have features as follows.
(1) The active species of a substance which is at least part of the raw materials for the ceramics may be a radical, an ion, or ozone obtained by activating a substance containing oxygen or nitrogen. Specifically, in the case of an oxide, radicals or ions of oxygen or ozone may be used as the active species. In the case of a nitride, radicals or ions of nitrogen may be used as the active species. As a method for generating radicals or ions, conventional methods such as methods of forming active species by using RF (high frequency) , microwaves, ECR (electron cyclotron resonance), an ozonizer, and the like can be given.
   The electromagnetic wave is appropriately selected depending on the composition of the ceramics, reactive species, active species, and the like. As a source for the electromagnetic wave, an eximer laser, halogen lamp, YAG laser (higher harmonic), or the like can be used. The active species concentration can be increased by selecting an electromagnetic wave which can cause oxygen or nitrogen to dissociate.
(2) In addition to the above active species, a radical or an ion obtained by activating inert gas (xenon, argon) may also be fed to the predetermined region. For example, use of xenon increases the active species concentration when forming active species of oxygen (oxygen radicals) using microwaves.

### (E) Fabrication device

According to a fourth aspect of the present invention, there is provided a ceramics fabrication device which has following features.
(1) This ceramics fabricating device may comprise:
   a base of a substrate on which ceramics is formed;
   a heating section;
   an active species feeder which feeds active species of a substance which is at least part of raw materials for the ceramics; and
   an electromagnetic wave generating section which provides an electromagnetic wave,
   wherein at least one of the active species and the electromagnetic wave is fed to a region for forming the ceramics.
(2) The fabrication device of the above (1) may further comprise a film forming section which forms a ceramic film or a film including a substance which is part of the raw materials for the ceramics, in a chamber.
(3) This ceramic fabricating device may comprise:
   a crystallization section which has a base of a substrate on which ceramics is formed, a heating section, an active species feeder which feeds active species of a substance which is at least part of raw materials for the ceramics, and an electromagnetic wave generating section which provides an electromagnetic wave, to feed at least one of the active species and the electromagnetic wave to a region for forming the ceramics; and
   a film forming section which is formed in a chamber differing from the chamber of the crystallization section.
(4) The fabrication device of the above (3) may further comprise a load-lock section between the crystallization section and the film forming section.
(5) In the fabrication device of the above (1) to (4), the base of the substrate may function as the heating section.
(6) In the fabrication device of the above (1) to (5), at least one of the active species feeder and the electromagnetic wave generating section may feed at least one of the active species and the electromagnetic wave to part of the substrate.
(7) In the fabrication device of the above (1) to (6), the substrate may be relatively moved when at least one of the active species and the electromagnetic wave is fed to the part of the substrate.
(8) In the fabrication device of the above (3), the film forming section may form a film by a coating method, the liquid source misted chemical deposition (LSMCD), the chemical vapor deposition (CVD), or a sputtering method.
(9) In the fabrication device of the above (2), the film forming section may form a film by LSMCD or CVD.

(F) Ceramics obtained by the fabrication methods according to the present invention can be used in various types of applications as follows.

(1) There is provided a semiconductor device comprising a capacitor which includes a dielectric film formed by the fabrication methods of the present invention. As examples of such a semiconductor device, a DRAM which uses paraelectrics obtained by the fabrication methods of the present invention as the dielectric film, a ferroelectric memory (FeRAM) device, and the like can be given.
(2) There is provided a piezoelectric device comprising a dielectric film formed by the fabrication methods of the present invention.

### BRIEF DESCRIPTION OF THE DRAWINGS

Figure 1 is a view schematically showing an example of the fabrication method according to the present invention.

Figure 2 is a view schematically showing an example of the fabrication method according to the present invention.

Figure 3 is a view schematically showing an example of the fabrication method according to the present invention.

Figure 4 is a view schematically showing a first embodiment of the fabrication method and fabrication device according to the present invention.

Figure 5 is a view schematically showing a second embodiment of the fabrication method and fabrication device according to the present invention.

Figure 6 is a view schematically showing a third embodiment of the fabrication method and fabrication device according to the present invention.

Figure 7 is a view schematically showing a fourth embodiment of the fabrication method and fabrication device according to the present invention.

Figure 8 is a view schematically showing a semiconductor device according to a fifth embodiment of the present invention.

### BEST MODE FOR CARRYING OUT THE INVENTION

### First embodiment

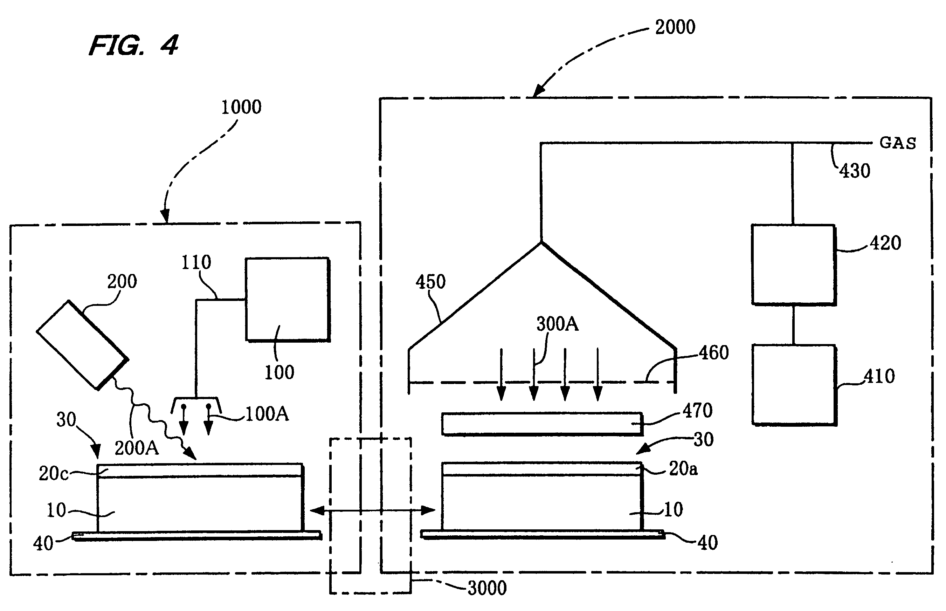

Figure 4 is a view schematically showing a method and a device for fabricating ceramics according to the present embodiment. The fabrication device shown in Figure 4 includes a film forming section 2000, a crystallization section 1000, and a load-lock section 3000. An object 30 to be treated is disposed so as to be able to go back and forth between the film forming section 2000 and the crystallization section 1000 through the load-lock section 3000.

There are no specific limitations to the film forming section 2000 insofar as a first ceramic film 20a is formed on a substrate 10. In the present embodiment, a system capable of performing LSMCD (Liquid Source Misted Chemical Deposition) is used. The film forming section 2000 includes a raw material tank 410 in which ceramics materials such as organic metals are stored, a mist-forming section 420 which forms a mist of the raw materials, a gas feeding section 430 for feeding carrier gas, and a raw material feeding section 450 for feeding the misted raw materials and gas to a specific region of the substrate 10 placed on a base section 40. A mesh 460 is provided at the end of the raw material feeding section 450. A mask 470 for patterning the first ceramic film 20a to be formed into a specific pattern is disposed between the substrate 10 and the raw material feeding section 450, as required. The base section 40 has a heating section for heating the substrate 10 to a specific temperature.

According to this film forming section 2000, the first ceramic film 20a is formed by the following steps.

The raw materials fed to the mist-forming section 420 from the raw material tank 410 are misted using ultrasonic waves, for example, to form a mist (droplets) with a particle diameter of 0.1 to 0.2 µm. The mist formed in the mist-forming section 420 and gas fed from the gas feeding section 430 are transferred to the raw material feeding section 450. Raw material species 300A are fed to the substrate 10 from the raw material feeding section 450, whereby the first ceramic film 20a in an amorphous state is formed on the substrate 10.

In the case of using organic metals as the raw materials, the first ceramic film 20a in an amorphous state is obtained by causing an organic metal complex to decompose (cleaning) by heating the substrate 10. This cleaning may be performed using RTA or a furnace in another room.

Since the first ceramic film 20a formed using an LSMCD method has appropriately distributed minute vacancies formed therein, the first ceramic film 20a is advantageous for crystallization because the atoms easily migrate. It is preferable that the first ceramic film 20a be formed to have a thickness of 5-30 nm, for example, in order to ensure effective crystallization in the succeeding crystallization step. If the thickness of the first ceramic film 20a is within this range, the crystal grain size can be decreased by the crystallization treatment without causing unevenness in the composition as described above. Therefore, ceramics having high crystallinity can be obtained.

The crystallization section 1000 includes an active species feeder 100 and an electromagnetic wave generating section 200. Active species 100A formed in the active species feeder 100 are fed to a specific region of the substrate 10 through a feeding passage 110. An electromagnetic wave 200A generated in the electromagnetic wave generating section 200 is applied to the region to which the active species 100A are fed. The active species feeder 100 and the electromagnetic wave generating section 200 are appropriately disposed so as not to prevent the active species 100A and the electromagnetic wave 200A from being fed.

In the crystallization section 1000, the migration energy of atoms in the first ceramic film 20a is increased by applying the active species 100A and the electromagnetic wave 200A to the first ceramic film 20a in an amorphous state formed in the film forming section 2000. As a result, the first ceramic film 20a is crystallized at a comparatively low temperature, specifically, at a temperature of less than 600°C, and preferably 450°C or less, whereby a second ceramic film 20b having high crystallinity is formed.

Formation of the first ceramic film 20a in the film forming section 2000 and formation of the crystal ceramic film 20c in the crystallization section 1000 may be repeated several times in order to obtain ceramic films with a specified thickness.

In particular, in the case of forming SBT which is layered perovskite, the growth rate differs depending on the crystal orientation. As a result, grooves or holes unfavorable for polycrystals tend to be formed. However, a homogenous film can be obtained while filling the above grooves or holes by repeatedly layering thin films as in the present embodiment.

According to the present embodiment, the first ceramic film 20a in which atoms easily migrate due to the presence of appropriate minute vacancies can be obtained by using an LSMCD method in the film forming section 2000. A large amount of migration energy can be provided to atoms by applying the active species 100A and the electromagnetic wave 200A to the first ceramic film 20a in the crystallization section 1000. As a result, crystallization can be suitably performed at a lower temperature in comparison with conventional devices.

### Second embodiment

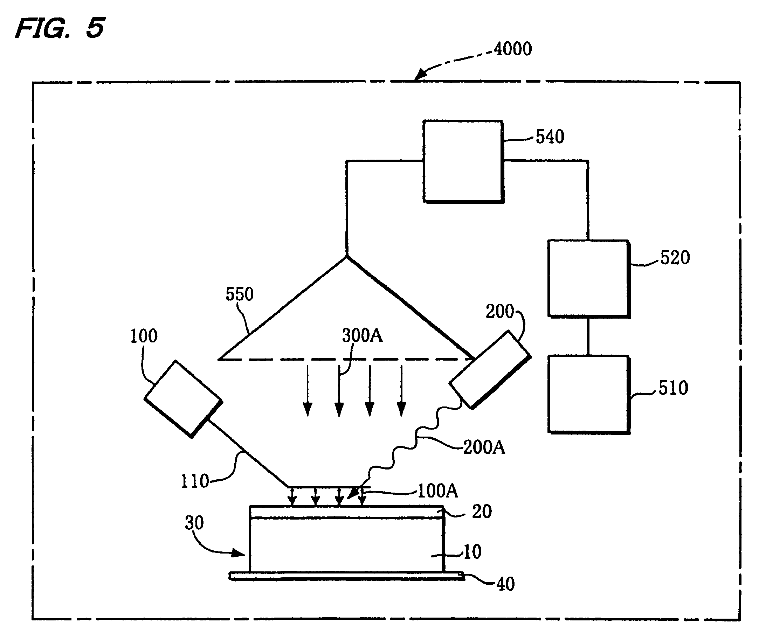

Figure 5 is a view schematically showing a film forming section 4000 according to the present embodiment. The film forming section 4000 is an example of a device capable of performing formation and crystallization of a film at the same time. In the present embodiment, film formation is performed by MOCVD, with which the crystallization method of the present invention is combined.

The film forming section 4000 includes a raw material tank 510, a mist-forming section 520, a heater 540, and a raw material feeding section 550 as a system for feeding raw materials. The raw material tank 510 and the mist-forming section 520 are the same as the raw material tank 410 and the mist-forming section 420 described in the first embodiment. Therefore, further description is omitted. The heater 540 gasifies the misted raw materials by heating. Reactive species 300A are fed to a specific region of the substrate 10 from the raw material feeding section 550.

The active species feeder 100 and the electromagnetic wave generating section 200 are disposed above the base section 40 at a position so as not to prevent the reactive species 300A from being fed. The active species 100A are applied to a specific region of the substrate 10 from the active species feeder 100. The electromagnetic wave 200A is applied from the electromagnetic wave generating section 200.

In the case of forming an oxide such as PZT or SBT, the wavelength of the electromagnetic wave is preferably 193-300 nm. Use of an electromagnetic wave within this wavelength range increases the migration of atoms in the oxide. Use of ArF at a wavelength of 193 nm as the electromagnetic wave allows oxygen to dissociate, thereby increasing the active species concentration.

According to the film forming section 4000 of the present embodiment, formation of a ceramic film by MOCVD and crystallization of the film by the active species 100A and the electromagnetic wave 200A are performed at the same time, whereby the ceramic film 20 is formed. A large amount of migration energy can be provided to atoms by applying the active species 100A and electromagnetic wave 200A to the ceramic film in the film forming section 4000 at the same time as the film formation. As a result, crystallization can be suitably performed at a lower temperature in comparison with conventional devices.

### Third embodiment

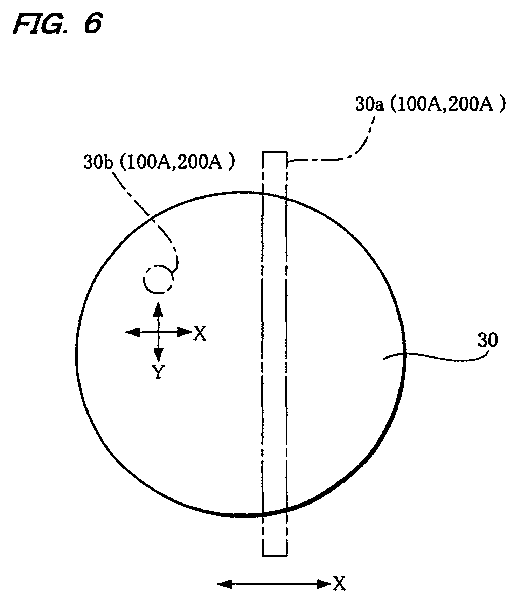

Figure 6 is a view showing an example of a method of feeding the active species 100A and the electromagnetic wave 200A. In the present embodiment, at least one of the active species 100A and the electromagnetic wave 200A, preferably both or at least the electromagnetic wave 200A is partly fed to the object 30 in the region in which the ceramics is formed.

Specifically, the active species 100A and the electromagnetic wave 200A are fed to a linear region 30a or a spot-shaped region 30b, as shown in Figure 6. The regions 30a and 30b to which the active species 100A and the electromagnetic wave 200A are fed are set so as to be moved relative to the object 30. As a method for moving the region 30a or 30b relative to the object 30, any of a method of moving the object 30, a method of moving the region 30a or 30b, and a method of moving the both of the object 30 and the region 30a or 30b may be employed. In the case where the active species 100A and the electromagnetic wave 200A are fed linearly, the region 30a or 30b is moved relative to the object 30 by moving at least one of the object 30 and the region 30a or 30b in a direction intersecting the linear region at right angles (X direction in Figure 6, for example). In the case where the active species 100A and the electromagnetic wave 200A are fed in the shape of a spot, at least one of the object 30 and the region 30a or 30b is moved in one direction (X direction or Y direction in Figure 6, for example).

Since the region 30a or 30b to which at least one of the active species 100A and the electromagnetic wave 200A is fed is specified, the energy of the active species 100A and the intensity of the electromagnetic wave 200A can be increased while preventing the temperature of the object 30 from increasing in comparison with the case of feeding the active species 100A and the electromagnetic wave 200A onto the entire surface of the object 30.

Since an increase in the intensity of the electromagnetic wave 200A results in an increase in the temperature of the object 30, the object 30 may be damaged due to heat depending on the type of the object 30. For example, in the case where a semiconductor device is formed on the substrate of the object 30, an oxide film may be formed or a MOS device may be damaged due to diffusion of impurities, thereby resulting in deterioration of the semiconductor device. However, according to the present invention, an increase in the temperature of the object 30 due to application of the electromagnetic wave can be prevented by specifying the region 30a or 30b.

The intensity of the electromagnetic wave 200A and the energy of the active species 100A are set while taking into consideration the above-described increase in the temperature of the object, composition of the ceramics, and the like.

### Fourth embodiment

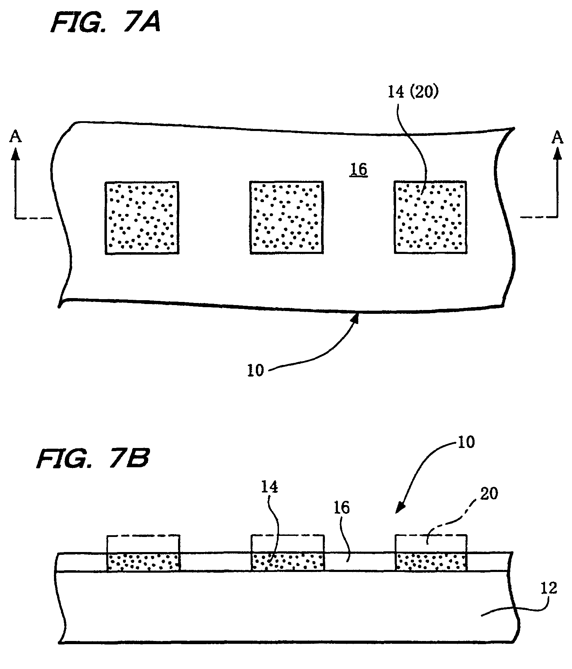

Figures 7A and 7B illustrate a modification example of the film-forming method of the present invention. Figure 7A is a plan view showing the substrate 10. Figure 7B is a cross-sectional view along the line A-A shown in Figure 7A.

The present embodiment illustrates an example of forming ceramics on part of the substrate 10. Since the area required to be heated is relatively decreased by partly forming ceramics in comparison with the case of forming ceramics over the entire surface, the amount of energy required for the heating treatment can be decreased. As a result, the temperature of the heating process can be relatively reduced. Therefore, according to the present embodiment, a reduction in the process temperature can be further achieved in addition to the reduction due to application of the active species and electromagnetic wave.

In the present embodiment, the substrate 10 includes a first substrate 12, and film-forming sections 14 and a non-film-forming section 16 which are formed on the first substrate 12.

The film-forming sections 14 are formed using a material having high chemical or physical affinity to the ceramics formed on the substrate 10, such as a material having good wettability with the raw materials or reactive species of the ceramics. On the contrary, the non-film-forming section 16 is formed using a material having poor chemical or physical affinity to the ceramics to be formed, such as a material having low wettability with the raw materials or reactive species of the ceramics. The ceramic film 20 with a specific pattern is formed by thus arranging the surface of the substrate 10 to dispose the film-forming sections 14 in a region in which it is desired to form a ceramic film 20.

In the case of forming a ferroelectric film as such a ceramic film, for example, iridium oxide may be used as the material for the film-forming sections 14, and a fluorine compound may be used as the material for the non-film-forming section 16.

The method of fabricating ceramics according to the present embodiment can be applied to various types of ceramics such as ferroelectrics. The method can be suitably applied to layered perovskite, in particular. In layered perovskite, oxygen, in particular, radicals (atomic oxygen) tend to be diffused in a direction intersecting the c-axis at right angles. Therefore, radicals easily migrate from the side of the ceramic film 20 in the heating process for crystallization. As a result, oxygen loss in perovskite is decreased and the polarization characteristics are improved, thereby preventing deterioration of fatigue characteristics, imprint characteristics, and the like.

### Fifth embodiment

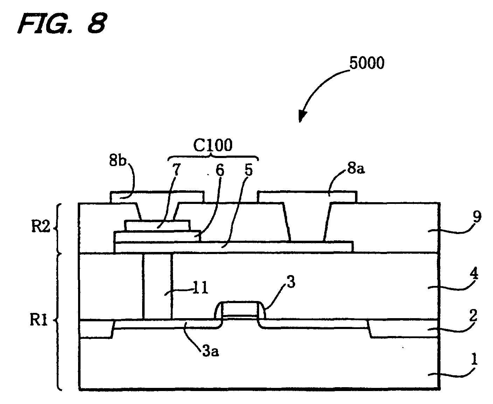

Figure 8 illustrates an example of a semiconductor device (ferroelectric memory device 5000) using the ferroelectrics obtained by the fabrication method according to the present invention.

The ferroelectric memory device 5000 includes a CMOS region R1, and a capacitor region R2 formed on the CMOS region R1. The CMOS region R1 has a conventional structure. Specifically, the CMOS region R1 includes a semiconductor substrate 1, an element isolation region 2 and a MOS transistor 3 formed on the semiconductor substrate 1, and an interlayer dielectric 4. The capacitor region R2 includes a capacitor C100 consisting of a lower electrode 5, a ferroelectric film 6, and an upper electrode 7, an interconnect layer 8a connected to the lower electrode 5, an interconnect layer 8b connected to the upper electrode 7, and an insulating layer 9. An impurity diffusion layer 3a of the MOS transistor 3 and the lower electrode 5 which makes up the capacitor C100 are connected through a contact layer 11 formed of polysilicon or a tungsten plug.

In the ferroelectric memory device 5000 according to the present embodiment, the ferroelectric (PZT, SBT) film 6 which makes up the capacitor C100 can be formed at a temperature lower than that for conventional ferroelectrics. For example, in the case of PZT, the ferroelectric film 6 can be formed at 500°C or less. In the case of SBT, the ferroelectric film 6 can be formed at less than 600°C. Therefore, since the CMOS region R1 can be prevented from being heat damaged, the capacitor C100 can be applied to highly integrated ferroelectric memory devices. Moreover, since the ferroelectric (PZT, SBT) film 6 can be formed at a temperature lower than that of conventional ferroelectrics, deterioration of interconnections or electrode sections can be prevented even if expensive materials such as iridium and platinum are not used as the materials for an interconnect layer (not shown) in the CMOS region R1 and the electrode sections 5 and 7 which make up the capacitor C100. Therefore, cheap aluminum alloys can be used as the materials for the interconnect layer and the electrode sections, thereby reducing cost.

In semiconductor devices such as a CMOS, a semiconductor process and a capacitor process are generally isolated in order to prevent contamination due to ferroelectrics (PZT, SBT). However, according to the fabrication method of the present invention, since the process temperature for the ferroelectrics can be decreased, capacitors can be continuously formed after performing a multilayer interconnection step, which is the final step in a conventional semiconductor process. Therefore, the number of processes which must be isolated can be decreased, whereby the process can be simplified. Moreover, since the fabrication method of the present invention does not need the isolation of the semiconductor process and the capacitor process, the method is advantageous for fabricating a semiconductor device including logic circuits, analog circuits, and the like in combination.

Dielectrics formed using the fabrication method of the present invention are not limited to the above ferroelectric memory device, but applied to various types of semiconductor devices. For example, in the case of a DRAM, the capacity of a capacitor can be increased by using paraelectrics with a high dielectric constant such as BST.

Dielectrics formed using the fabrication method of the present invention may be applied to other applications such as piezoelectrics of piezoelectric devices used for actuators.

Nitrides (silicon nitride, titanium nitride) formed using the fabrication method of the present invention may be applied to passivation films and local interconnect films of semiconductor devices, and the like.

## Claims

1. A method of fabricating ceramics, comprising
a step of forming a ceramic film by feeding an electromagnetic wave and an active species of a substance which is at least part of raw materials for the ceramics to a predetermined region.

2. The method of fabricating ceramics as defined in claim 1, wherein a film including a substance which is part of raw materials for the ceramics is formed in the predetermined region.

3. A method of fabricating ceramics, comprising
a step of feeding an active species and an electromagnetic wave to a first ceramic film to form a second ceramic film which has a crystal structure differing from the crystal structure of the first ceramic film.

4. The method of fabricating ceramics as defined in claim 3, wherein the first ceramic film is formed of ceramics in an amorphous state.

5. The method of fabricating ceramics as defined in claim 3, wherein the first ceramic film is formed of ceramics having low crystallinity.

6. The method of fabricating ceramics as defined in claim 1 or 2,
wherein the active species of a substance which is at least part of the raw materials for the ceramics is a radical, an ion, or ozone obtained by activating a substance containing oxygen or nitrogen.

7. The method of fabricating ceramics as defined in any one of claims 3 to 5, wherein the active species is a radical or an ion obtained by activating a substance containing oxygen or nitrogen.

8. The method of fabricating ceramics as defined in any one of claims 1 to 7, wherein in addition to the active species, an ion obtained by activating inert gas are also fed to the predetermined region.

9. The method of fabricating ceramics as defined in claim 1 or 2, wherein the thickness of the ceramic film is 5 nm to 30 nm.

10. The method of fabricating ceramics as defined in any one of claims 3 to 5, wherein the thickness of the second ceramic film is 5 nm to 30 nm.

11. A method of fabricating ceramics,
wherein a film having a predetermined thickness is formed by repeating several times a step of forming a ceramic film having a predetermined thickness by feeding at least one of an electromagnetic wave and active species of a substance which is at least part of raw materials for the ceramics to a predetermined region.

12. The method of fabricating ceramics as defined in claim 11, wherein a film including a substance which is part of the raw materials for the ceramics is formed in the predetermined region.

13. The method of fabricating ceramics as defined in claim 11 or 12, wherein the thickness of the ceramic film is 5 nm to 30 nm.

14. The method of fabricating ceramics as defined in any one of claims 11 to 13, wherein the ceramic film is formed on part of a substrate.

15. A method of fabricating ceramics, comprising:
a first step of forming a first ceramic film; and
a second step of feeding at least one of an electromagnetic wave and active species to the first ceramic film to form a second ceramic film which has a crystal structure differing from the crystal structure of the first ceramic film,
wherein a film having a predetermined thickness is formed by performing alternately the first and second steps.

16. The method of fabricating ceramics as defined in claim 15, wherein the thickness of the first ceramic film is 5 nm to 30 nm.

17. The method of fabricating ceramics as defined in claim 15 or 16, wherein the first ceramic film is formed on part of a substrate.

18. The method of fabricating ceramics as defined in claim 15, wherein the first ceramic film is formed of ceramics in an amorphous state.

19. The method of fabricating ceramics as defined in claim 15, wherein the first ceramic film is formed of ceramics having low crystallinity.

20. The method of fabricating ceramics as defined in any one of claims 11 to 14,
wherein the active species of a substance which is at least part of the raw materials for the ceramics is a radical, an ion, or ozone obtained by activating a substance containing oxygen or nitrogen.

21. The method of fabricating ceramics as defined in any one of claims 15 to 19,
wherein the active species is a radical, an ion, or ozone obtained by activating a substance containing oxygen or nitrogen.

22. The method of fabricating ceramics as defined in any one of claims 11 to 21, wherein in addition to the active species, ions obtained by activating inert gas is also fed to the predetermined region.

23. A method of fabricating ceramics,
wherein a region for forming a ceramic film is part of a substrate; and
the method comprising a step of forming the ceramic film by feeding at least one of an electromagnetic wave and active species of a substance which is at least part of raw materials for the ceramics to a predetermined region.

24. The method of fabricating ceramics as defined in claim 23, wherein a film including a substance which is part of the raw materials for the ceramics is formed in the predetermined region.

25. A method of fabricating ceramics,
wherein a region for forming a ceramic film is part of a substrate; and
the method comprising a step of feeding at least one of active species and an electromagnetic wave to a first ceramic film to form a second ceramic film which has a crystal structure differing from the crystal structure of the first ceramic film.

26. The method of fabricating ceramics as defined in any one of claims 23 to 25, further comprising a step of:
forming a film-forming region having affinity to ceramics to be formed and a non-film-forming region having no affinity to ceramics to be formed on a surface of the substrate, to form self-alignably a ceramic film in the film-forming region.

27. The method of fabricating ceramics as defined in claim 25 or 26, wherein the first ceramic film is formed of ceramics in an amorphous state.

28. The method of fabricating ceramics as defined in claim 25 or 26, wherein the first ceramic film is formed of ceramics having low crystallinity.

29. The method of fabricating ceramics as defined in claim 23 or 24,
wherein the active species of a substance which is at least part of the raw materials for the ceramics is a radical, an ion, or ozone obtained by activating a substance containing oxygen or nitrogen.

30. The method of fabricating ceramics as defined in any one of claims 25 to 28, wherein the active species is a radical or an ion obtained by activating a substance containing oxygen or nitrogen.

31. The method of fabricating ceramics as defined in any one of claims 23 to 30, wherein in addition to the active species, ions obtained by activating inert gas are fed to the predetermined region.

32. The method of fabricating ceramics as defined in claim 23 or 24, wherein the thickness of the ceramic film is 5 nm to 30 nm.

33. The method of fabricating ceramics as defined in any one of claims 25 to 28, wherein the thickness of the second ceramic film is 5 nm to 30 nm.

34. The method of fabricating ceramics as defined in any one of claims 23 to 33, wherein the step of forming the ceramics is repeated several times.

35. The method of fabricating ceramics as defined in any one of claims 1 to 34,
wherein at least one of the active species and the electromagnetic wave is fed to part of a substrate.

36. The method of fabricating ceramics as defined in claim 35,
wherein the substrate is relatively moved when at least one of the active species and the electromagnetic wave is fed to the part of the substrate.

37. The method of fabricating ceramics as defined in claim 3 to 5, 15 to 19, or 25,
wherein the first ceramic film is formed by a coating method, the liquid source misted chemical deposition (LSMCD), the chemical vapor deposition (CVD), or a sputtering method.

38. The method of fabricating ceramics as defined in claim 37, wherein the first ceramic film is formed by LSMCD or CVD.

39. The method of fabricating ceramics as defined in any one of claims 1 to 38,
wherein the ceramic film or the second ceramic film is formed of ferroelectrics.

40. The method of fabricating ceramics as defined in any one of claims 1 to 39,
wherein the ceramic film or the second ceramic film is formed at a temperature of less than 600°C.

41. A ceramics fabrication device, comprising:
a base of a substrate on which ceramics is formed;
a heating section;
an active species feeder which feeds active species of a substance which is at least part of raw materials for the ceramics; and
an electromagnetic wave generating section which provides an electromagnetic wave,
wherein at least one of the active species and the electromagnetic wave is fed to a region for forming the ceramics.

42. The ceramics fabrication device as defined in claim 41, further comprising
a film forming section which forms a ceramic film or a film including a substance which is part of the raw materials for the ceramics, in a chamber.

43. A ceramics fabrication device, comprising:
a crystallization section which has a base of a substrate on which ceramics is formed, a heating section, an active species feeder which feeds active species of a substance which is at least part of raw materials for the ceramics, and an electromagnetic wave generating section which provides an electromagnetic wave, to feed at least one of the active species and the electromagnetic wave to a region for forming the ceramics; and
a film forming section which is formed in a chamber differing from the chamber of the crystallization section.

44. The ceramics fabrication device as defined in claim 43, further comprising a load-lock section between the crystallization section and the film forming section.

45. The ceramics fabrication device as defined in any one of claims 41 to 44, wherein the base of the substrate functions as the heating section.

46. The ceramics fabrication device as defined in any one of claims 41 to 45,
wherein at least one of the active species feeder and the electromagnetic wave generating section feeds at least one of the active species and the electromagnetic wave to part of the substrate.

47. The ceramics fabrication device as defined in claim 46,
wherein the substrate is relatively moved when at least one of the active species and the electromagnetic wave is fed to the part of the substrate.

48. The device for fabricating ceramics as defined in claim 43,
wherein the film forming section forms a film by a coating method, the liquid source misted chemical deposition (LSMCD), the chemical vapor deposition (CVD), or a sputtering method.

49. The device for fabricating ceramics as defined in claim 48, wherein the film forming section forms a film by LSMCD or CVD.

50. A semiconductor device comprising a capacitor which includes a dielectric film formed by the fabrication method as defined in any one of claims 1 to 40.

51. A piezoelectric device comprising a dielectric film formed by the fabrication method as defined in any one of claims 1 to 40.

## Amended claims

### Amended claims under Art. 19.1 PCT

**52.** (Amended) A method of fabricating ceramics, comprising:
a step of forming a film-forming region having affinity to ceramics to be formed and a non-film-forming region having no affinity to ceramics to be formed on a surface of a substrate;
a step of forming a ceramic film in the film-forming region in a self-aligning way by feeding a fine particle of a substance which is at least part of raw materials for a ceramic film by a coating method of liquid source misted chemical deposition (LSMCD) to the film-forming region having affinity to ceramics and the non-film-forming region having no affinity to ceramics; and
a step of crystallizing the ceramic film by feeding an electromagnetic wave to the ceramic film.

**53.** (Amended) The method of fabricating ceramics as defined in claim 52, comprising
a step of feeding an active species of a substance which is part of raw materials for the ceramic film to the ceramic film, in the step of forming the ceramic film or the step of crystallizing the ceramic film.

**54.** (Amended) A method of fabricating ceramics, comprising:
a step of forming a film-forming region having affinity to ceramics to be formed and a non-film-forming region having no affinity to ceramics to be formed on a surface of a substrate;
a step of forming a ceramic film in the film-forming region in a self-aligning way by feeding a fine particle of a substance which is at least part of raw materials for a ceramic film by a coating method of liquid source misted chemical deposition (LSMCD) to the film-forming region having affinity to ceramics and the non-film-forming region having no affinity to ceramics; and
a step of crystallizing the ceramic film by feeding an active species of a substance which is part of raw materials for the ceramic film to the ceramic film.

**55.** (Amended) The method of fabricating ceramics as defined in claim 54, comprising
a step of crystallizing the ceramic film by feeding an electromagnetic wave to the ceramic film, in the step of forming the ceramic film or the step of crystallizing the ceramic film.
